(19) **Europäisches Patentamt / European Patent Office / Office européen des brevets**

(11) **EP 4 541 773 A1**

(12) **EUROPEAN PATENT APPLICATION**

(43) Date of publication:
23.04.2025 Bulletin 2025/17

(51) International Patent Classification (IPC):
*C01G 53/506* (2025.01)   *H01M 4/525* (2010.01)

(21) Application number: 24205037.5

(22) Date of filing: 07.10.2024

(52) Cooperative Patent Classification (CPC):
C01G 53/506; H01M 4/525

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 19.10.2023 KR 20230140151

(71) Applicant: ECOPRO BM CO., LTD.
Cheongju-si, Chungcheongbuk-do 28116 (KR)

(72) Inventors:
• OH, Seong Ho
  Cheongju-si
  Chungcheongbuk-do 28116 (KR)
• RYU, Mun Hwa
  Cheongju-si
  Chungcheongbuk-do 28116 (KR)
• HEO, Jun Hee
  Cheongju-si
  Chungcheongbuk-do 28116 (KR)
• HAN, Kyu Suk
  Cheongju-si
  Chungcheongbuk-do 28116 (KR)
• CHOI, Yoon Young
  Cheongju-si
  Chungcheongbuk-do 28116 (KR)

(74) Representative: BCKIP Part mbB
MK1
Landsbergerstraße 98, 3.Stock
80339 München (DE)

(54) **POSITIVE ELECTRODE ACTIVE MATERIAL AND LITHIUM SECONDARY BATTERY COMPRISING THE SAME**

(57)   The present invention relates to a positive electrode active material and a lithium secondary battery including the same, and more particularly, to a single-crystal type positive electrode active material which has a uniform particle size distribution and high sharpness of the particle size distribution, and a lithium secondary battery including the same.

FIG. 1

EP 4 541 773 A1

**Description**

BACKGROUND

**1. Field of the Invention**

The present invention relates to a positive electrode active material and a lithium secondary battery including the same, and more particularly, to a single-crystal type positive electrode active material which has a uniform particle size distribution and high sharpness of the particle size distribution, and a lithium secondary battery including the same.

**2. Discussion of Related Art**

Batteries store power by using materials capable of undergoing electrochemical reactions at a positive electrode and a negative electrode. A representative example of batteries is a lithium secondary battery that stores electrical energy by the difference in chemical potential when lithium ions are intercalated/deintercalated into/from the positive electrode and the negative electrode.

The lithium secondary battery is manufactured by using materials capable of reversible intercalation/deintercalation of lithium ions as positive and negative electrode active materials and filling an organic electrolyte or a polymer electrolyte between the positive and negative electrodes.

A lithium composite oxide is used as a positive electrode active material for a lithium secondary battery, and as an example, composite oxides such as $LiCoO_2$, $LiMn_2O_4$, $LiNiO_2$, $LiMnO_2$, and the like are being studied.

Among the positive electrode active materials, $LiCoO_2$ is the most widely used due to its excellent lifetime and charge/discharge efficiency, but its price competitiveness is low because cobalt, which is used as a raw material, is expensive.

Lithium manganese oxides such as $LiMnO_2$ and $LiMn_2O_4$ have excellent thermal stability and low costs, but have small capacity and poor high temperature characteristics. In addition, an $LiNiO_2$-based positive electrode active material has high discharge capacity, but is difficult to synthesize due to active cation mixing of Li and Ni, and the rate performance and lifetime of the synthesized positive electrode active material are very low.

Therefore, in order to improve the low rate performance and lifetime of $LiNiO_2$ while maintaining its high reversible capacity, ternary lithium composite oxides such as the so-called NCM (Ni-Co-Mn) and NCA (Ni-Co-Al), in which part of the nickel is substituted with cobalt, manganese, and/or aluminum, or quaternary lithium composite oxides such as NCMA (Ni-Co-Mn-Al) have been developed. Since the reversible capacity is reduced as the nickel content in the ternary or quaternary lithium composite oxide decreases, research has been widely conducted to increase the nickel content in the lithium composite oxide.

A typical ternary or quaternary lithium composite oxide has the form of secondary particles in which tens to hundreds or more of primary particles are aggregated, and it was reported that the stability (lifetime characteristics, and the like) of the positive electrode active material can be improved as the number of primary particles constituting the secondary particles decreases. Such lithium composite oxide with a reduced number of primary particles is referred to as lithium composite oxide with a single-crystal structure or lithium composite oxide with a single particle structure.

For example, it is disclosed in the Journal of the Electrochemical Society, Volume 164, Number 7, A1534-A1544 (published on May 23, 2017) that the stability of lithium composite oxide ($LiNi_{0.5}Mn_{0.3}Co_{0.2}O_2$) with a single-crystal structure and a particle size of 2 to 3 $\mu$m is partially improved compared to a lithium composite oxide with a polycrystalline structure and the same composition.

However, as disclosed in the above document, when the calcination temperature is excessively increased for single crystallization of the lithium composite oxide constituting the positive electrode active material, or the amount of lithium relative to the transition metal in the lithium composite oxide is excessively increased, cation mixing in the crystal structure may increase.

In particular, when the cation mixing increases in the lithium composite oxide with a single-crystal structure, the surface resistance of the lithium composite oxide may change as a phase other than the layered crystal structure (such as a rock-salt phase) is formed, or early deterioration may occur.

When single crystallization of lithium composite oxide is induced under harsh calcination conditions (such as over-calcination at high calcination temperatures), it is difficult to induce uniform particle growth and agglomeration occurs between particles, making it impossible to obtain a positive electrode active material with a uniform particle size distribution.

A positive electrode active material including a lithium composite oxide with a single-crystal structure may be manufactured by synthesizing and disintegrating secondary particles in which a plurality of primary particles are aggregated. However, the cost for processing the positive electrode active material rapidly increases due to the disintegration process, and damage may be caused to the surface of the lithium composite oxide during the disintegration process. Defects on the surface of the lithium composite oxide may change the surface resistance of the lithium composite oxide. In addition, gas may be generated due to side reactions with an electrolyte through defects on the surface, and cracks may occur along defects on the surface.

Therefore, there is a need to develop a single-crystal type positive electrode active material, which has a uniform particle size distribution without a separate disintegration process after calcinating a precursor by inducing uniform particle growth and reducing inter-particle agglomeration.

## SUMMARY OF THE INVENTION

In the lithium secondary battery market, the growth of lithium secondary batteries for electric vehicles is the driving force, and accordingly, the demand for positive electrode active materials used in the lithium secondary batteries is continuously increasing.

For example, conventionally, lithium secondary batteries using lithium iron phosphate (LFP) have been mainly used in terms of ensuring safety, but recently, the use of nickel-based lithium composite oxides, which have a higher energy capacity per weight than LFP, is expanding (of course, relatively inexpensive LFP is still used to reduce costs).

In general, nickel-based lithium composite oxides, which have recently been mainly used as positive electrode active materials for high-capacity lithium secondary batteries, have a ternary composition such as NCM (Ni-Co-Mn) and NCA (Ni-Co-Al) or a quaternary composition such as NCMA (Ni-Co-Mn-Al).

As described above, as the number of primary particles constituting secondary particles is reduced in order to realize high capacity of the ternary or quaternary nickel-based lithium composite oxide, the stability (lifetime characteristics and the like) of the positive electrode active material may be improved.

However, according to commercialized processes, changes in the crystal structure of lithium composite oxide may occur due to harsh calcination conditions. In addition, since it is difficult to induce uniform particle growth under harsh calcination conditions, a disintegration process is inevitably involved, which rapidly increases the cost for processing the positive electrode active material.

Therefore, the present invention is directed to providing a single-crystal type positive electrode active material which has a uniform particle size distribution by inducing uniform particle growth without harsh calcination conditions and a disintegration process and reducing inter-particle agglomeration.

The present invention is directed to providing a positive electrode active material with a high sharpness of a particle size distribution due to uniform particle growth and reduced inter-particle agglomeration.

The present invention is also directed to providing a lithium secondary battery using the positive electrode active material defined herein.

The objects of the present invention are not limited to the above-described objects, and other objects and advantages of the present invention that are not described can be understood by the following description and will be more clearly understood by the embodiments of the present invention. In addition, it is apparent that the objects and advantages of the present invention can be realized by the means and combinations thereof indicated in the claims.

According to an aspect of the present invention, there is provided a positive electrode active material including a lithium composite oxide capable of intercalation/deintercalation of lithium, wherein the lithium composite oxide satisfies Equations 1 to 3 below:

$$[\text{Equation 1}]$$
$$D_{90}/D_{10} \leq 3.62$$

$$[\text{Equation 2}]$$
$$D_{max} - D_{90} < 2.0 \ \mu m$$

$$[\text{Equation 3}]$$
$$D_{max}/D_{min} < 5.19$$

(in Equations 1 to 3, from the volume cumulative particle size distribution graph obtained by laser diffraction particle size distribution measurement, the particle size that corresponds to 10% of the volume cumulative amount is $D_{10}$, the particle size that corresponds to 50% of the volume cumulative amount is $D_{50}$, the particle size that corresponds to 90% of the volume cumulative amount is $D_{90}$, the minimum particle size in the volume cumulative particle size distribution graph is $D_{min}$, and the maximum particle size in the volume cumulative particle size distribution graph is $D_{max}$).

The lithium composite oxide constituting the positive electrode active material according to the embodiments may be a single-crystal type with a uniform particle size distribution and high sharpness of the particle size distribution.

In an embodiment of the present invention, the $D_{50}$ of the lithium composite oxide may range from 2 $\mu$m to 8 $\mu$m, and the $D_{max}$ of the lithium composite oxide may be 15 $\mu$m or less.

In an embodiment of the present invention, the lithium composite oxide may satisfy at least one or both selected from the following Equations 4 and 5.

$$[\text{Equation 4}]$$
$$D_{50}/D_{10} < 1.19$$

$$[\text{Equation 5}]$$
$$D_{max} - D_{50} < 7.8 \ \mu\text{m}$$

In an embodiment of the present invention, the lithium composite oxide includes at least lithium and a transition metal. The transition metal may include at least one, at least two, at least three, or all selected from nickel, cobalt, manganese, and aluminum.

The lithium composite oxide may be represented by Chemical Formula 1 below.

[Chemical Formula 1] $\quad\quad Li_aNi_{1-(b+c+d)}CO_bM1_cM2_dO_2$

Wherein, M1 is at least one selected from Mn and Al, M2 is at least one selected from Na, K, Mg, Ca, Ba, Mn, B, Ce, Hf, Ta, Cr, F, Al, V, Ti, Fe, Zr, Zn, Si, Y, Nb, Ga, Sn, Mo, W, P, Sr, Ge, Nd, Gd, and Cu, M1 and M2 are different, and $0.5 \leq a \leq 1.5$, $0 \leq b \leq 0.20$, $0 \leq c \leq 0.30$, $0 \leq d \leq 0.10$.

In an embodiment of the present invention, the lithium composite oxide may be in at least one form selected from single particles and secondary particles in which a plurality of primary particles are aggregated. The secondary particles may be an aggregate of 1 to 10 primary particles.

According to another aspect of the present invention, there is provided a positive electrode including the positive electrode active material described above.

According to still another aspect of the present invention, there is provided a lithium secondary battery using the positive electrode described above.

BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:

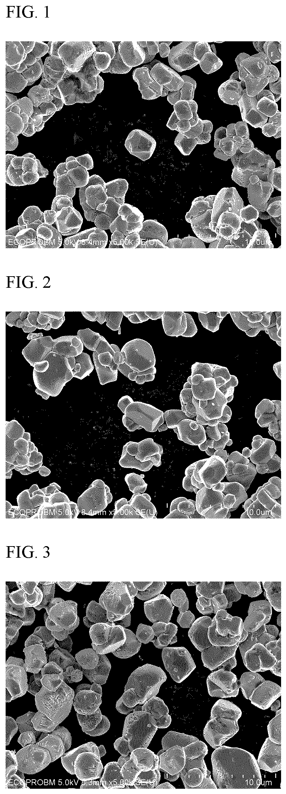

FIG. 1 is an SEM image of a positive electrode active material according to Example 1;
FIG. 2 is an SEM image of a positive electrode active material according to Example 2;
FIG. 3 is an SEM image of a positive electrode active material according to Example 3;

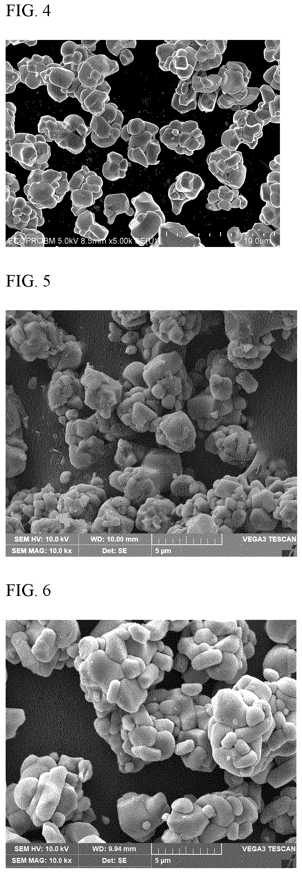

FIG. 4 is an SEM image of a positive electrode active material according to Comparative Example 1;
FIG. 5 is an SEM image of a positive electrode active material according to Comparative Example 2; and
FIG. 6 is an SEM image of a positive electrode active material according to Comparative Example 3.

DETAILED DESCRIPTION OF EXEMPLARY EMBODIMENTS

For a better understanding of the present invention, certain terms are defined herein for convenience. Unless otherwise defined herein, scientific and technical terms used in the present invention will have meanings commonly understood by those skilled in the art. In addition, unless otherwise specified in the context, the singular should be understood to include the plural, and the plural should be understood to include the singular. Amounts or ratios indicated herein are molar amounts or molar ratios, unless otherwise specified in the context.

Positive electrode active material

The positive electrode active material according to one aspect of the present invention is capable of reversible intercalation/deintercalation of lithium ions and includes a lithium composite oxide.

The lithium composite oxide is a metal composite oxide capable of intercalation/deintercalation of lithium ions and has a layered crystal structure belonging to the R3-m space group. The lithium composite oxide having a layered crystal structure exhibits a distinct peak in the diffraction angle (2θ) range of 18° to 20° in the diffraction pattern obtained from XRD analysis.

In an embodiment of the present invention, the lithium composite oxide includes at least lithium and a transition metal. The lithium composite oxide may include at least one, at least two, at least three, or all of nickel, cobalt, manganese, and aluminum. The lithium composite oxide may be preferably a lithium nickel-based composite oxide containing nickel. The lithium composite oxide may be a lithium nickel-based composite oxide containing nickel and at least one transition metal. In this case, the lithium composite oxide may be a lithium nickel-based composite oxide including nickel and cobalt. Further, the lithium nickel-based composite oxide optionally comprises at least one main group metal, at least one transition metal, at least one metalloid and/or at least one non-metal.

In an embodiment of the present invention, in order to improve the low rate performance and lifetime characteristics of $LiNiO_2$ while maintaining its high reversible capacity, the lithium nickel-based composite oxide may be a ternary lithium composite oxide such as NCM (Ni-Co-Mn) and NCA (Ni-Co-Al), in which part of the nickel is substituted with cobalt, manganese, and/or aluminum, or a quaternary lithium composite oxide such as NCMA (Ni-Co-Mn-Al). The ternary or quaternary lithium composite oxide may further include dopants other than nickel, cobalt, manganese, and aluminum. In another embodiment of the present invention, the lithium nickel-based composite oxide may be a cobalt-free lithium composite oxide that does not include cobalt in bulk particles. The cobalt-free lithium composite oxide may further include dopants other than nickel, cobalt, manganese, and aluminum.

In an embodiment of the present invention, the lithium composite oxide may be represented by Chemical Formula 1 below.

[Chemical Formula 1]     $Li_aNi_{1-(b+c+d)}Co_bM1_cM2_dO_2$

Here, M1 is at least one selected from Mn and Al, M2 is at least one selected from Na, K, Mg, Ca, Ba, Mn, B, Ce, Hf, Ta, Cr, F, Al, V, Ti, Fe, Zr, Zn, Si, Y, Nb, Ga, Sn, Mo, W, P, Sr, Ge, Nd, Gd, and Cu, M1 and M2 are different from each other, and $0.5 \leq a \leq 1.5$, $0 \leq b \leq 0.20$, $0 \leq c \leq 0.30$, $0 \leq d \leq 0.10$.

In Chemical Formula 1, a, which represents the ratio of lithium to all elements other than lithium in the lithium composite oxide (Li/(Ni+Co+M1+M2)), may be 0.5 or more and 1.5 or less, 0.75 or more and 1.25 or less, 0.90 or more and 1.1 or less, or 0.95 or more and 1.05 or less.

In an embodiment of the present invention, the lithium composite oxide may be a lithium nickel-based composite oxide, in which the mole fraction of nickel to all elements other than lithium in the lithium composite oxide (Ni/(Ni+Co+M1+M2)) is 70% or more. In this case, in Chemical Formula 1, b+c+d is 0.30 or less. In other words, the lithium composite oxide according to the embodiment of the present invention is a lithium nickel-based composite oxide in which a mole fraction of nickel to all elements other than lithium (Ni/(Ni+Co+M1+M2)) is 70% or more and which has a layered crystal structure belonging to the R3-m space group.

According to another embodiment of the present invention, the mole fraction of nickel to all elements other than lithium in the lithium composite oxide (Ni/(Ni+Co+M1+M2)) may be 75% or more (here, b+c+d is 0.25 or less), 80% or more (here, b+c+d is 0.20 or less), 85% or more (here, b+c+d is 0.15 or less), or 90% or more (here, b+c+d is 0.10 or less).

When the lithium composite oxide includes cobalt, the mole fraction of cobalt to all elements other than lithium in the lithium composite oxide (Co/(Ni+Co+M1+M2)) may be 20% or less, 15% or less, 10% or less, or 5% or less. When the lithium composite oxide includes cobalt, b in Chemical Formula 1 is greater than 0, and when the lithium composite oxide is a cobalt-free lithium composite oxide that does not include cobalt, b in Chemical Formula 1 is 0.

When the lithium composite oxide includes manganese and/or aluminum, the mole fraction of manganese and/or aluminum to all elements other than lithium in the lithium composite oxide (M1/(Ni+Co+M1+M2)) is 30% or less, 20% or less, 15% or less, 10% or less, or 5% or less. When the lithium composite oxide includes manganese and/or aluminum, c in Chemical Formula 1 is greater than 0.

In Chemical Formula 1, M2 refers to the dopant present in the lithium composite oxide. The dopant may be present in a doped state within the crystal lattice of the primary particles. In addition, in Chemical Formula 1, M2 may optionally include an element derived from a molten salt-based flux and/or a metal oxide-based dopant used in the step of calcinating the precursor of the lithium composite oxide.

When the lithium composite oxide includes a dopant, d in Chemical Formula 1 is greater than 0, and when the lithium composite oxide does not include a dopant, d in Chemical Formula 1 is 0.

In addition, the content of dopant to all elements other than lithium in the lithium composite oxide is smaller than the content of nickel, cobalt, and M1. For example, in the lithium composite oxide, the mole fraction of the dopant to all elements other than lithium (M2/(Ni+Co+M1+M2)) is 10% or less (where d is 0.10 or less), 5% or less (where d is 0.05 or less), 4% or less (where d is 0.04 or less), 3% or less (where d is 0.03 or less), 2% or less (where d is 0.02 or less), 1% or less (where d is 0.01 or less), 0.5% or less (where d is 0.005 or less), 0.4% or less (where d is 0.004 or less), 0.3% or less (where d is 0.003 or less), 0.2% or less (where d is 0.002 or less), or 0.1% or less (where d is 0.001 or less).

When the lithium composite oxide optionally include a dopant, the dopant may include at least one selected from Na, K, Mg, Ca, Ba, Mn, B, Ce, Hf, Ta, Cr, F, Al, V, Ti, Fe, Zr, Zn, Si, Y, Nb, Ga, Sn, Mo, W, P, Sr, Ge, Nd, Gd, and Cu, or at least one selected from B, Al, Nb, and W. The type and combination of the dopant may be appropriately selected within a range that does not negatively affect the electrochemical properties and stability of the positive electrode active material.

The upper and lower limits of the contents of nickel, cobalt, M1, and M2 defined in Chemical Formula 1 may be appropriately selected within a range that satisfies the above-described definitions.

The lithium composite oxide may be present in at least one form selected from single particles and secondary particles in which a plurality of primary particles are aggregated. Thus, the positive electrode active material may be present as an aggregate of single particles and secondary particles. However, when the agglomeration is reduced by inducing uniform particle growth during the positive electrode active material manufacturing process, as the ratio of single particles to secondary particles in the aggregate increases, a positive electrode active material with a more uniform particle size distribution and, in particular, a high sharpness of the particle size distribution may be obtained. When using a positive electrode active material having a particle size distribution with high sharpness, the capacity and lifetime characteristics of the lithium secondary battery may be improved. Here, the narrow peak width of the particle size distribution observed from the volume cumulative particle size distribution graph may refer to high sharpness of the particle size distribution.

When the single particles are aggregated and present as secondary particles, each single particle constituting the secondary particles may be referred to as a primary particle. The composition of single particles, primary particles, and secondary particles may all be expressed by Chemical Formula 1. The single particles, primary particles, and secondary particles are all present as particles capable of intercalation/deintercalation of lithium.

The single particle and the primary particle may have a rod shape, an elliptical shape, and/or an irregular shape. Additionally, unless specifically intended during the manufacturing process, primary particles of various shapes may be present in the same positive electrode active material. The primary particle refers to a particle unit in which no grain boundary is present when observed at a magnification of 5,000 to 20,000x using a scanning electron microscope.

The single particle and the primary particle may have an average particle diameter of 0.5 $\mu$m to 10 $\mu$m, 0.5 $\mu$m to 8 $\mu$m, 0.5 $\mu$m to 6 $\mu$m, 0.5 $\mu$m to 5 $\mu$m, 1 $\mu$m to 10 $\mu$m, 1 $\mu$m to 8 $\mu$m, 1 $\mu$m to 6 $\mu$m, 1 $\mu$m to 5 $\mu$m, 2 $\mu$m to 10 $\mu$m, 2 $\mu$m to 8 $\mu$m, 2 $\mu$m to 6 $\mu$m, or 2 $\mu$m to 5 $\mu$m. The average particle diameter of the single and primary particles may be the average value of the length in the major axis direction and the length in the minor axis direction ([major axis length + minor axis length]/2) of the single and primary particles. Also, the average particle diameter of the primary particle can be calculated as the average value of the particle diameters of all primary particles observed from the surface SEM image of the lithium manganese-based oxide.

Additionally, the lithium composite oxide is a single-crystal type lithium composite oxide. The single-crystal type means that single particles or primary particles, which are the minimum particle unit constituting the lithium composite oxide, are present as a single crystallite.

When secondary particles are present in the aggregate, the average particle diameter of secondary particles may be 0.5 $\mu$m to 15 $\mu$m, 1.0 $\mu$m to 12 $\mu$m, 1.0 $\mu$m to 10 $\mu$m, 2.0 $\mu$m to 12 $\mu$m, or 2.0 $\mu$m to 10 $\mu$m. The average particle diameter of secondary particles may be calculated as the average value of the particle diameters of secondary particles confirmed from the SEM image. The average particle diameter of secondary particles may vary depending on the number of primary particles constituting the secondary particles.

The particle size distribution of the lithium composite oxide in the positive electrode active material may be measured using a laser diffraction method. For example, after dispersing secondary particles in a dispersion medium and irradiating the same with ultrasonic waves at about 28 kHz at an output of 60 W using a commercially available laser diffraction particle size measurement device (such as Microtrac MT 3000) to obtain a volume cumulative particle size distribution graph, and the particle size corresponding to 10%, 50%, and 90% of the volume accumulation amount, the minimum particle size of the volume accumulation particle size distribution graph, and the maximum particle size of the volume accumulation particle size distribution graph may be calculated therefrom.

The particle size corresponding to 50% of the volume accumulation amount is defined as the average particle diameter ($D_{50}$). From the volume cumulative particle size distribution graph obtained by laser diffraction particle size distribution measurement, the particle size that is 10% of the volume accumulation amount is defined as $D_{10}$, the particle size that is 50% of the volume accumulation amount is defined as $D_{50}$, the particle size that is 90% of the volume accumulation amount is defined as $D_{90}$, the minimum particle size in the volume cumulative particle size distribution graph is defined as $D_{min}$, and the maximum particle size in the volume cumulative particle size distribution graph is defined as $D_{max}$. The term "particle size" is used herein interchangeably with the term "particle diameter". Any particle diameter mentioned herein are median volume-based particle diameters as determined by laser diffraction, unless specified otherwise in the context.

In an embodiment of the present invention, the $D_{50}$ of the lithium composite oxide may range from 2 $\mu$m to 8 $\mu$m, 3 $\mu$m to 7 $\mu$m, or 4 $\mu$m to 6 $\mu$m, and the $D_{max}$ of the lithium composite oxide may be 15 $\mu$m or less, 14 $\mu$m or less, or 13 $\mu$m or less.

The $D_{min}$ of the lithium composite oxide may range from 0.5 $\mu$m to 4 $\mu$m, 1 $\mu$m to 4 $\mu$m, or 2 $\mu$m to 3.2 $\mu$m, and $D_{10}$

may range from 1 μm to 4 μm, 2 μm to 4 μm, or 2.5 μm to 3.5 μm, and $D_{90}$ may range from 6 μm to 15 μm, 8 μm to 12 μm, or 9 μm to 12 μm.

The upper and lower limits of $D_{min}$, $D_{10}$, $D_{50}$, $D_{90}$, and $D_{max}$, defined above, may be appropriately selected within a range that satisfies Equations 1 to 3, Equations 1 to 4, Equations 1 to 3 and Equation 5, or Equations 1 to 5 below.

Equations 1 to 5 below are calculated based on an aggregate including single particles and secondary particles.

The lithium composite oxide in the positive electrode active material satisfies Equation 1 below.

### [Equation 1]

$$D_{90}/D_{10} \leq 3.62$$

When $D_{90}/D_{10}$ has a value of 3.62 or less, the particle size difference between the lithium composite oxide with a relatively small particle size and the lithium composite oxide with a relatively large particle size in the positive electrode active material may be reduced.

$D_{90}/D_{10}$ may range from 3.3 to 3.8, 3.3 to 3.7, 3.4 to 3.65, 3.42 to 3.62, or 3.45 to 3.62.

In the positive electrode active material, the lithium composite oxide satisfies Equation 2 below.

### [Equation 2]

$$D_{max} - D_{90} < 2.0 \text{ μm}$$

$D_{max} - D_{90}$ refers to the difference between the maximum particle size and the particle size that corresponds to 90% of the volume cumulative amount in the aggregate, and a $D_{max} - D_{90}$ of less than 2.0 μm means that the sharpness of the particle size distribution is high.

$D_{max} - D_{90}$ may be less than 2.0 μm, 1.9 μm or less, or 1.8 μm or less. In addition, in order to achieve appropriate sharpness of the particle size distribution, $D_{max} - D_{90}$ may be preferably 0.75 μm, or more than 1 μm.

In the positive electrode active material, the lithium composite oxide satisfies Equation 3 below.

### [Equation 3]

$$D_{max}/D_{min} < 5.19$$

$D_{max}/D_{min}$ is the ratio of the maximum particle size to the minimum particle size in the aggregate, and as $D_{max}/D_{min}$ increases, the difference between the minimum particle size and the maximum particle size in the aggregate increases, and thus the uniformity of the particle size distribution decreases, and the sharpness of the particle size distribution inevitably decreases.

$D_{max}/D_{min}$ may be less than 5.19, 5.1 or less, 5.0 or less, 4.95 or less, or 4.92 or less. In addition, to achieve appropriate sharpness of the particle size distribution, $D_{max}/D_{min}$ is preferably 2, or more than 3.

According to the present invention, in the calcination step of the precursor of the lithium composite oxide, by inducing uniform particle growth without harsh calcination conditions and a disintegration process through the use of a combination of a molten salt-based flux and a metal oxide-based dopant, a positive electrode active material with reduced inter-particle agglomeration may be obtained.

The positive electrode active material obtained through the above process has a uniform particle size distribution, and in particular, has high sharpness of the particle size distribution. When a positive electrode active material with high sharpness of the particle size distribution is used, the capacity and lifetime characteristics of a lithium secondary battery may be improved.

In this way, a positive electrode active material with a uniform particle size distribution and high sharpness of the particle size distribution preferably satisfies all of Equations 1 to 3.

Additionally, in order to further improve the uniformity and sharpness of the particle size distribution of the lithium composite oxide in the positive electrode active material, the lithium composite oxide may satisfy at least one or both selected from the following Equations 4 and 5.

### [Equation 4]

$$D_{50}/D_{10} < 1.19$$

$D_{50}/D_{10}$ is the ratio of the particle size (average particle diameter) that corresponds to 50% of the volume cumulative amount and the particle size that corresponds to 10% of the volume cumulative amount in the aggregate, and

as $D_{50}/D_{10}$ increases, the difference between the average particle size and $D_{10}$, which is close to the minimum particle size, in the volume cumulative particle size distribution graph increases, and thus the uniformity of the particle size distribution decreases, and the sharpness of the particle size distribution inevitably decreases.

$D_{50}/D_{10}$ may be less than 1.19, 1.18 or less, 1.17 or less, or 1.16 or less. In addition, in order to achieve appropriate sharpness of the particle size distribution, $D_{50}/D_{10}$ is preferably more than 1.

$$[\text{Equation 5}]$$
$$D_{max} - D_{50} < 7.8 \ \mu m$$

$D_{max} - D_{50}$ refers to the difference between the maximum particle size and the particle size (average particle diameter) that corresponds to 50% of the volume cumulative amount in the aggregate, and like $D_{max} - D_{90}$, when $D_{max} - D_{50}$ has a value of less than 7.8 $\mu m$, the sharpness of the particle size distribution may be improved.

$D_{max} - D_{50}$ may be less than 7.8 $\mu m$, 7.6 $\mu m$ or less, 7.4 $\mu m$ or less, or 7.2 $\mu m$ or less. In addition, in order to achieve appropriate sharpness of the particle size distribution, $D_{max} - D_{50}$ is preferably 3 $\mu m$, or more than 4 $\mu m$.

As described above, the lithium composite oxide may be present in at least one form selected from single particles and secondary particles in which a plurality of primary particles are aggregated, and accordingly, the positive electrode active material may be present as an aggregate of single particles and secondary particles. In other words, the positive electrode active material may be defined as an aggregate of a plurality of lithium composite oxides with the same and/or different grain boundary densities.

The grain boundary density may be obtained by substituting the number of primary particles (P) lying on an imaginary straight line (L) crossing the center of the lithium composite oxide in the long axis direction in the cross-sectional SEM image of the lithium composite oxide into Equation 6 below.

Grain boundary density = (Number of interfaces (B) between primary particles lying on an imaginary straight line (L)/ Number of primary particles (P) lying on an imaginary straight line (L))

For example, when the lithium composite oxide is a single particle, the number of interfaces (grain boundaries) between primary particles lying on an imaginary straight line is 0, so the grain boundary density will have a value of 0. On the other hand, when the number of primary particles (P) lying on an imaginary straight line (L) is 2 and the number of interfaces (B) between primary particles lying on an imaginary straight line (L) is 1, the grain boundary density will have a value of 0.5.

As the average grain boundary density of the lithium composite oxide in the aggregate is closer to 0, the ratio of the lithium composite oxide that is present as single particles to the secondary particles in the aggregate is high.

In addition, the lithium composite oxide that is present as secondary particles in the aggregate may be in a state in which 2 to 100, 2 to 50, 2 to 30, 2 to 20, or 2 to 10 primary particles are aggregated.

Lithium secondary battery

According to another aspect of the present invention, there is provided a positive electrode including a positive electrode current collector and a positive electrode active material layer formed on the positive electrode current collector. The positive electrode active material layer may include the positive electrode active material according to various embodiments of the present invention. Since the content of positive electrode active material is the same as described above, detailed description will be omitted for convenience, and only the remaining components not described above will be described below.

The positive electrode current collector is not particularly limited as long as it does not cause a chemical change in a battery and has conductivity, and for example, stainless steel, aluminum, nickel, titanium, calcined carbon, or aluminum or stainless steel whose surface is treated with carbon, nickel, titanium or silver may be used. In addition, the positive electrode current collector may conventionally have a thickness of 3 to 500 $\mu m$, and fine irregularities may be formed on the surface of the current collector, thereby increasing the adhesive strength of a positive electrode active material. For example, the positive electrode current collector may be used in various forms such as a film, a sheet, a foil, a net, a porous body, foam, a non-woven fabric, etc.

The positive electrode active material layer may be prepared by coating the positive electrode current collector with a positive electrode slurry composition including the positive electrode active material, a conductive material, and optionally as needed, a binder.

Here, the positive electrode active material is included at 80 to 99 wt%, and specifically, 85 to 98.5 wt% with respect to the total weight of a positive electrode slurry for forming the positive electrode active material layer. When the positive electrode active material is included in the above content range, excellent capacity characteristics may be exhibited, but the present invention is not limited thereto.

The conductive material is used to impart conductivity to an electrode, and is not particularly limited as long as it has electron conductivity without causing a chemical change in a battery. A specific example of the conductive material may be graphite such as natural graphite or artificial graphite; a carbon-based material such as carbon black, acetylene black, Ketjen black, channel black, furnace black, lamp black, thermal black or a carbon fiber; a metal powder or metal fiber consisting of copper, nickel, aluminum, or silver; a conductive whisker consisting of zinc oxide or potassium titanate; a conductive metal oxide such as titanium oxide; or a conductive polymer such as a polyphenylene derivative, and one or a mixture of two or more thereof may be used. The conductive material may be generally contained at 0.1 to 15 wt% with respect to the total weight of a positive electrode slurry for forming the positive electrode active material layer.

The binder serves to improve the adhesion between particles of the positive electrode active material and the adhesion between the positive electrode active material and the current collector. A specific example of the binder may be polyvinylidene fluoride (PVDF), a vinylidene fluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, tetrafluoroethylene, polyethylene, polypropylene, an ethylene-propylene-diene polymer (EPDM), a sulfonated EPDM, styrene butadiene rubber (SBR), fluorine rubber, or various copolymers thereof, and one or a mixture of two or more thereof may be used. The binder may be included at 0.1 to 15 wt% with respect to the total weight of a positive electrode slurry for forming the positive electrode active material layer.

The positive electrode may be manufactured according to a conventional method of manufacturing a positive electrode, except that the above-described positive electrode active material is used. Specifically, the positive electrode may be manufactured by coating the positive electrode current collector with a positive electrode slurry composition prepared by dissolving or dispersing the positive electrode active material, and optionally, a binder and a conductive material in a solvent, and drying and rolling the resulting product.

The solvent may be a solvent generally used in the art, and may be dimethyl sulfoxide (DMSO), isopropyl alcohol, N-methylpyrrolidone (NMP), acetone or water, and one or a mixture of two or more thereof may be used. In consideration of the coating thickness and production yield of a slurry, the solvent is used at a sufficient amount for dissolving or dispersing the positive electrode active material, the conductive material and the binder and then imparting a viscosity for exhibiting excellent thickness uniformity when the slurry is applied to manufacture a positive electrode.

In addition, in another exemplary embodiment, the positive electrode may be manufactured by casting the positive electrode slurry composition on a separate support, and laminating a film obtained by delamination from the support on the positive electrode current collector.

Moreover, still another aspect of the present invention provides an electrochemical device including the above-described positive electrode. The electrochemical device may be, specifically, a battery, a capacitor, and more specifically, a lithium secondary battery.

The lithium secondary battery may specifically include a positive electrode, a negative electrode disposed opposite to the positive electrode, and a separator and a liquid electrolyte, which are interposed between the positive electrode and the negative electrode. Here, since the positive electrode is the same as described above, for convenience, detailed description of the positive electrode will be omitted, and other components which have not been described above will be described in detail.

The lithium secondary battery may further include a battery case accommodating an electrode assembly of the positive electrode, the negative electrode and the separator, and optionally, a sealing member for sealing the battery case.

The negative electrode may include a negative electrode current collector and a negative electrode active material layer disposed on the negative electrode current collector.

The negative electrode current collector is not particularly limited as long as it has high conductivity without causing a chemical change in a battery, and may be, for example, copper, stainless steel, aluminum, nickel, titanium, calcined carbon, or copper or stainless steel whose surface is treated with carbon, nickel, titanium or silver, or an aluminum-cadmium alloy. In addition, the negative electrode current collector may generally have a thickness of 3 to 500 $\mu$m, and like the positive electrode current collector, fine irregularities may be formed on the current collector surface, thereby enhancing the binding strength of the negative electrode active material. For example, the negative electrode current collector may be used in various forms such as a film, a sheet, a foil, a net, a porous body, foam, a non-woven fabric, etc.

The negative electrode active material layer may be formed by coating the negative electrode current collector with a negative electrode slurry composition including the negative electrode active material, a conductive material, and optionally as needed, a binder.

As the negative electrode active material, a compound enabling the reversible intercalation and deintercalation of lithium may be used. A specific example of the negative electrode active material may be a carbonaceous material such as artificial graphite, natural graphite, graphitized carbon fiber or amorphous carbon; a metallic compound capable of alloying with lithium, such as Si, Al, Sn, Pb, Zn, Bi, In, Mg, Ga, Cd, an Si alloy, an Sn alloy or an Al alloy; a metal oxide capable of doping and dedoping lithium such as $SiO_\beta$ ($0<\beta<2$), $SnO_2$, vanadium oxide, or lithium vanadium oxide; or a composite including the metallic compound and the carbonaceous material such as an Si-C composite or an Sn-C composite, and any one or a mixture of two or more thereof may be used. In addition, as the negative electrode active material, a metallic lithium thin film may be used. In addition, as a carbon material, both low-crystalline carbon and high-crystalline carbon may be used. Representative examples of the low-crystalline carbon include soft carbon and hard carbon, and representative examples of the high-crystalline carbon include amorphous, sheet-type, flake-type, spherical or fiber-type natural or artificial graphite, Kish graphite, pyrolytic carbon, mesophase pitch-based carbon fiber, meso-carbon microbeads, mesophase pitches, and high-temperature calcined carbon such as petroleum or coal tar pitch derived cokes.

The negative electrode active material may be included at 80 to 99 wt% with respect to the total weight of a negative electrode slurry for forming the negative electrode active material layer.

The binder is a component aiding bonding between a conductive material, an active material and a current collector, and may be generally added at 0.1 to 10 wt% with respect to the total weight of a negative electrode slurry for forming the negative electrode active material layer. Examples of the binder may include polyvinylidene fluoride (PVDF), polyvinyl alcohol, carboxymethylcellulose (CMC), starch, hydroxypropylcellulose, regenerated cellulose, polyvinylpyrrolidone, tetrafluoroethylene, polyethylene, polypropylene, ethylene-propylene-diene monomer (EPDM), sulfonated EPDM, styrene butadiene rubber, nitrile-butadiene rubber, fluorine rubber, and various copolymers thereof.

The conductive material is a component for further improving the conductivity of the negative electrode active material, and may be added at 10 wt% or less, and preferably, 5 wt% or less with respect to the total weight of a negative electrode slurry for forming the negative electrode active material layer. The conductive material is not particularly limited as long as it does not cause a chemical change in the battery, and has conductivity, and may be, for example, graphite such as natural graphite or artificial graphite; carbon black such as acetylene black, Ketjen black, channel black, furnace black, lamp black or thermal black; a conductive fiber such as a carbon fiber or a metal fiber; a conductive powder such as fluorinated carbon, aluminum, or nickel powder; a conductive whisker such as zinc oxide or potassium titanate; a conductive metal oxide such as titanium oxide; or a conductive material such as a polyphenylene or a derivative thereof.

In an exemplary embodiment, the negative electrode active material layer may be prepared by coating the negative electrode current collector with a negative electrode slurry composition prepared by dissolving or dispersing a negative electrode active material, and optionally, a binder and a conductive material in a solvent, and drying the coated composition, or may be prepared by casting the negative electrode slurry composition on a separate support and then laminating a film delaminated from the support on the negative electrode current collector.

Meanwhile, in the lithium secondary battery, the separator is not particularly limited as long as it is generally used in a lithium secondary battery to separate a negative electrode from a positive electrode and provide a diffusion path for lithium ions, and particularly, the separator has low resistance to ion mobility of a liquid electrolyte and an excellent electrolyte solution impregnability. Specifically, a porous polymer film, for example, a porous polymer film prepared of a polyolefin-based polymer such as an ethylene homopolymer, a propylene homopolymer, an ethylene/butene copolymer, an ethylene/hexene copolymer and an ethylene/methacrylate copolymer, or a stacked structure including two or more layers thereof may be used. In addition, a conventional porous non-woven fabric, for example, a non-woven fabric formed of a high melting point glass fiber or a polyethylene terephthalate fiber may be used. In addition, a coated separator including a ceramic component or a polymer material may be used to ensure thermal resistance or mechanical strength, and may be optionally used in a single- or multilayered structure.

In addition, the electrolyte used in the present invention may be an organic electrolyte, an inorganic electrolyte, a solid polymer electrolyte, a gel-type polymer electrolyte, a solid inorganic electrolyte, or a molten-type inorganic electrolyte, which is able to be used in the production of a lithium secondary battery, but the present invention is not limited thereto.

Specifically, the electrolyte may include an organic solvent and a lithium salt.

The organic solvent is not particularly limited as long as it can serve as a medium enabling the movement of ions involved in an electrochemical reaction of a battery. Specifically, the organic solvent may be an ester-based solvent such as methyl acetate, ethyl acetate, $\gamma$-butyrolactone, or $\varepsilon$-caprolactone; an ether-based solvent such as dibutyl ether or tetrahydrofuran; a ketone-based solvent such as cyclohexanone; an aromatic hydrocarbon-based solvent such as benzene or fluorobenzene; a carbonate-based solvent such as dimethyl carbonate (DMC), diethyl carbonate (DEC), methyl ethyl carbonate (MEC), ethyl methyl carbonate (EMC), ethylene carbonate (EC), or propylene carbonate (PC); an alcohol-based solvent such as ethyl alcohol or isopropyl alcohol; a nitrile-based solvent such as R-CN (R is a linear, branched or cyclic C2 to C20 hydrocarbon group, and may include a double bonded aromatic ring or an ether bond); an amide-based solvent such as dimethylformamide; a dioxolane-based solvent such as 1,3-dioxolane; or a sulfolane-based solvent. Among these, a carbonate-based solvent is preferably used, and a mixture of a cyclic carbonate (for example, ethylene carbonate or propylene carbonate) having high ion conductivity and high permittivity to increase the charging/-discharging performance of a battery and a low-viscosity linear carbonate-based compound (for example, ethyl methyl carbonate, dimethyl carbonate or diethyl carbonate) is more preferably used. In this case, by using a mixture of a cyclic carbonate and a chain-type carbonate in a volume ratio of approximately 1:1 to 1:9, the electrolyte solution may exhibit excellent performance.

The lithium salt is not particularly limited as long as it is a compound capable of providing a lithium ion used in a lithium secondary battery. Specifically, the lithium salt may be $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$. The concentration of the lithium salt is preferably in the range of 0.1 to 2.0M. When the concentration of the lithium salt is included in the above-mentioned range, since the electrolyte has suitable conductivity and viscosity, the electrolyte solution can exhibit excellent electrolytic performance and lithium ions can effectively migrate.

When the electrolyte used herein is a solid electrolyte, for example, a solid inorganic electrolyte such as a sulfide-based solid electrolyte, an oxide-based solid electrolyte, a nitride-based solid electrolyte, or a halide-based solid electrolyte may be used, and preferably, a sulfide-based solid electrolyte is used.

As a material for a sulfide-based solid electrolyte, a solid electrolyte containing Li, an X element (wherein, X is at least one selected from P, As, Sb, Si, Ge, Sn, B, Al, Ga and In) and S may be used. Examples of the sulfide-based solid electrolyte material may include $Li_2S-P_2S_5$, $Li_2S-P_2S-LiX$ (wherein, X is a halogen element such as I or Cl), $Li_2S-P_2S_5-Li_2O$, $Li_2S-P_2S_5-Li_2O-LiI$, $Li_2S-SiS_2$, $Li_2S-SiS_2-LiI$, $Li_2S-SiS_2-LiBr$, $Li_2S-SiS_2-LiCl$, $Li_2S-SiS_2-B_2S_3-LiI$, $Li_2S-SiS_2-P_2S_5-LiI$, $Li_2S-B_2S_3$, $Li_2S-P_2S_5-Z_mS_n$ (wherein, m and n are integers, and Z is Ge, Zn or Ga), $Li_2S-GeS_2$, $Li_2S-SiS_2-Li_3PO_4$, and $Li_2S-SiS_2-Li_pMO_q$ (wherein, p and q are integers, and M is P, Si, Ge, B, Al, Ga or In).

A solid electrolyte, and preferably, a sulfide-based solid electrolyte may be amorphous, crystalline, or a state in which an amorphous phase and crystalline phase are mixed.

Materials for an oxide-based solid electrolyte include $Li_7La_3Zr_2O_{12}$, $Li_{7-x}La_3Zr_{1-x}Nb_xO_{12}$, $Li_{7-3x}La_3Zr_2Al_xO_{12}$, $Li_{3x}La_{2/3-x}TiO_3$, $Li_{1+x}Al_xTi_{2-x}(PO_4)_3$, $Li_{1+x}Al_xGe_{2-x}(PO_4)_3$, $Li_3PO_4$, $Li_{3+x}PO_4 \cdot {}_xN_x$ (LiPON), and $Li_{2+2x}Zn_{1-x}GeO_4$ (LISI-CON).

The above-described solid electrolyte may be disposed as a separate layer (solid electrolyte layer) between a positive electrode and a negative electrode. In addition, the solid electrolyte may be partially included in a positive electrode active material layer of the positive electrode independent of the solid electrolyte layer, or the solid electrolyte may be partially included in a negative electrode active material of the negative electrode independent of the solid electrolyte layer.

To enhance the lifetime characteristics of the battery, inhibit a decrease in battery capacity, and enhance the discharge capacity of the battery, the electrolyte may further include one or more types of additives, for example, a haloalkylene carbonate-based compound such as difluoroethylene carbonate, pyridine, triethylphosphite, triethanolamine, cyclic ether, ethylene diamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol or aluminum trichloride, in addition to the components of the electrolyte. Here, the additive(s) may be included at 0.1 to 5 wt% with respect to the total weight of the electrolyte.

Since the lithium secondary battery including the positive electrode active material according to the present invention stably exhibits an excellent discharge capacity, excellent output characteristics and excellent lifetime characteristics, it is useful in portable devices such as a mobile phone, a notebook computer and a digital camera and an electric vehicle field such as a hybrid electric vehicle (HEV).

The outer shape of the lithium secondary battery according to the present invention is not particularly limited, but may be a cylindrical, prismatic, pouch or coin type. In addition, the lithium secondary battery may be used in a battery cell that is not only used as a power source of a small device, but also preferably used as a unit battery for a medium-to-large battery module including a plurality of battery cells.

According to still another exemplary embodiment of the present invention, a battery module including the lithium secondary battery as a unit cell and/or a battery pack including the same is provided.

The battery module or the battery pack may be used as a power source of any one or more medium-to-large devices including a power tool; an electric motor vehicle such as an electric vehicle (EV), a hybrid electric vehicle, and a plug-in hybrid electric vehicle (PHEV); and a power storage system.

Hereinafter, the present invention will be described in further detail with reference to examples. However, these examples are merely provided to exemplify the present invention, and thus the scope of the present invention will not be construed to be limited by these examples.

## Preparation Example 1. Manufacture of positive electrode active material

### Example 1

An $NiCoMn(OH)_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter ($D_{50}$) of the hydroxide precursor was 3.0 $\mu$m.

The hydroxide precursor and LiOH (Li/(Ni+Co+Mn) mol ratio = 1.05) were mixed and then heat-treated (first calcination) at 790 °C in an $O_2$ atmosphere for 12 hours to obtain a lithium composite oxide. Before the first calcination, 4.0 mol% of $NaNO_3$ and 0.1 mol% of $ZrO_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an $O_2$ atmosphere for 12 hours to obtain a positive electrode active material including the lithium composite oxide.

Example 2

An $NiCoMn(OH)_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter ($D_{50}$) of the hydroxide precursor was 3.0 $\mu$m.

The hydroxide precursor and LiOH (Li/(Ni+Co+Mn) mol ratio = 1.05) were mixed and then heat-treated (first calcination) at 790 °C in an $O_2$ atmosphere for 12 hours to obtain a lithium composite oxide. Before the first calcination, 3.0 mol% of $NaNO_3$ and 0.1 mol% of $ZrO_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an $O_2$ atmosphere for 12 hours to obtain a positive electrode active material including the lithium composite oxide.

Example 3

An $NiCoMn(OH)_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter ($D_{50}$) of the hydroxide precursor was 3.0 $\mu$m.

The hydroxide precursor and LiOH (Li/(Ni+Co+Mn) mol ratio = 1.05) were mixed and then heat-treated (first calcination) at 790 °C in an $O_2$ atmosphere for 12 hours to obtain a lithium composite oxide. Before the first calcination, 5.0 mol% of $NaNO_3$ and 0.1 mol% of $ZrO_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an $O_2$ atmosphere for 12 hours to obtain a positive electrode active material including the lithium composite oxide.

Example 4

An $NiCoMn(OH)_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter ($D_{50}$) of the hydroxide precursor was 3.0 $\mu$m.

The hydroxide precursor and LiOH (Li/(Ni+Co+Mn) mol ratio = 1.05) were mixed and then heat-treated (first calcination) at 790 °C in an $O_2$ atmosphere for 12 hours to obtain a lithium composite oxide. Before the first calcination, 8.0 mol% of $NaNO_3$ and 0.1 mol% of $ZrO_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an $O_2$ atmosphere for 12 hours to obtain a positive electrode active material including the lithium composite oxide.

Comparative Example 1

An $NiCoMn(OH)_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter ($D_{50}$) of the hydroxide precursor was 3.0 $\mu$m.

The hydroxide precursor and LiOH (Li/(Ni+Co+Mn) mol ratio = 1.05) were mixed and then heat-treated (first calcination) at 790 °C in an $O_2$ atmosphere for 12 hours to obtain a lithium composite oxide. Before the first calcination, 2.0 mol% of $NaNO_3$ and 0.1 mol% of $ZrO_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an $O_2$ atmosphere for 12 hours to obtain a positive electrode active material including the lithium composite oxide.

Comparative Example 2

An NiCoMn(OH)$_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter (D$_{50}$) of the hydroxide precursor was 3.0 μm.

The hydroxide precursor and LiOH (Li/(Ni+Co+Mn) mol ratio = 1.05) were mixed and then heat-treated (first calcination) at 790 °C in an O$_2$ atmosphere for 12 hours to obtain a lithium composite oxide. Before the first calcination, 4.0 mol% of NaNO$_3$ was added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an O$_2$ atmosphere for 12 hours to obtain a positive electrode active material including the lithium composite oxide.

Comparative Example 3

An NiCoMn(OH)$_2$ hydroxide precursor (Ni:Co:Mn = 91:8:1 (at%)) of a lithium composite oxide was synthesized using nickel sulfate, cobalt sulfate, and manganese sulfate through a known co-precipitation method. The average particle diameter (D$_{50}$) of the hydroxide precursor was 3.0 μm.

The hydroxide precursor and LiOH (Li/(Ni+Co+Mn) mol ratio = 1.05) were mixed and then heat-treated (first calcination) at 790 °C in an O$_2$ atmosphere for 12 hours to obtain a lithium composite oxide. Before the first calcination, 0.1 mol% of ZrO$_2$, as a metal oxide-based dopant, was added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an O$_2$ atmosphere for 12 hours to obtain a positive electrode active material including the lithium composite oxide.

Comparative Example 4

An NiCoMn(OH)$_2$ hydroxide precursor (Ni:Co:Mn = 95:4:1 (at%)) of a lithium composite oxide was synthesized using nickel sulfate, cobalt sulfate, and manganese sulfate through a known co-precipitation method. The average particle diameter (D$_{50}$) of the hydroxide precursor was 3.0 μm.

The hydroxide precursor and LiOH (Li/(Ni+Co+Mn) mol ratio = 1.05) were mixed and then heat-treated (first calcination) at 790 °C in an O$_2$ atmosphere for 12 hours to obtain a lithium composite oxide. Before the first calcination, 10.0 mol% of NaNO$_3$ and 0.1 mol% of ZrO$_2$, as a metal oxide-based dopant, were added.

After completing the first calcination, the lithium composite oxide was added to distilled water, stirred for 1 hour, and dried in a vacuum dryer at 120 °C for 12 hours.

Afterward, heat treatment (second calcination) was performed at 700 °C in an O$_2$ atmosphere for 12 hours to obtain a positive electrode active material including the lithium composite oxide.

Preparation Example 2. Manufacture of lithium secondary battery (half-cell)

94 wt% of each positive electrode active material manufactured according to Preparation Example 1, 3 wt% of carbon black, and 3 wt% of a PVDF binder were dispersed in 30 g of N-methyl-2 pyrrolidone (NMP) to prepare a positive electrode slurry. The positive electrode slurry was uniformly applied on an aluminum thin film with a thickness of 15 μm and vacuum dried at 135 °C to manufacture a positive electrode for a lithium secondary battery.

A half-cell was manufactured using a lithium foil as a counter electrode to the positive electrode, a porous polyethylene membrane (Celgard 2300, thickness: 25 μm) as a separator, and an electrolyte in which LiPF$_6$ was dissolved at a concentration of 1.15 M in a mixed solvent of ethylene carbonate and ethyl methyl carbonate at a volume ratio of 3:7.

**Experimental Example 1. Particle size distribution analysis of positive electrode active material**

The particle size distribution of lithium composite oxide in each positive electrode active material prepared according to Preparation Example 1 was analyzed using a known laser diffraction method. Specifically, after dispersing each positive electrode active material in a dispersion medium and irradiating the same with ultrasonic waves at about 28 kHz at an output of 60 W using a laser diffraction particle size measurement device (Microtrac MT 3000), a volume cumulative particle size distribution graph was obtained.

Afterward, from the volume cumulative particle size distribution graph, the particle size corresponding to 10%, 50%, and 90% of the volume cumulative amount, the minimum particle size of the volume cumulative particle size distribution graph, and the maximum particle size of the volume cumulative particle size distribution graph were calculated.

The analysis results are shown in Tables 1 and 2 below.

[Table 1]

| Classification | $D_{min}$ | $D_{10}$ | $D_{50}$ | $D_{90}$ | $D_{max}$ |
|---|---|---|---|---|---|
| Example 1 | 2.5 | 2.9 | 5.3 | 10.5 | 12 |
| Example 2 | 2.7 | 3.1 | 5.6 | 11.1 | 13 |
| Example 3 | 2.6 | 3.0 | 5.6 | 10.5 | 12 |
| Example 4 | 2.7 | 3.1 | 5.8 | 10.7 | 12 |
| Comparative Example 1 | 2.7 | 3.2 | 6.2 | 12.3 | 14 |
| Comparative Example 2 | 2.6 | 4.2 | 8.5 | 15.0 | 23 |
| Comparative Example 3 | 1.1 | 3.2 | 7.2 | 12.7 | 18 |
| Comparative Example 4 | 2.5 | 3.9 | 8.0 | 15.1 | 23 |

[Table 2]

| Classification | $D_{90}/D_{10}$ | $D_{max}-D_{90}$ | $D_{max}/D_{min}$ | $D_{50}/D_{10}$ | $D_{max}-D_{50}$ |
|---|---|---|---|---|---|
| Example 1 | 3.62 | 1.80 | 4.92 | 1.16 | 7.0 |
| Example 2 | 3.58 | 1.70 | 4.74 | 1.15 | 7.2 |
| Example 3 | 3.50 | 1.30 | 4.54 | 1.15 | 6.2 |
| Example 4 | 3.45 | 1.10 | 4.37 | 1.15 | 6.0 |
| Comparative Example 1 | 3.84 | 1.70 | 5.19 | 1.19 | 7.8 |
| Comparative Example 2 | 3.58 | 8.03 | 8.85 | 1.61 | 14.6 |
| Comparative Example 3 | 3.97 | 5.30 | 16.36 | 2.91 | 10.8 |
| Comparative Example 4 | 3.83 | 7.95 | 9.35 | 1.60 | 15.0 |

Experimental Example 2. Evaluation of electrochemical properties of lithium secondary battery (half-cell)

For the lithium secondary batteries (half-cell) manufactured in Preparation Example 2, charge/discharge experiments were performed using an electrochemical analysis device (Toscat-3100 from TOYO SYSTEM CO., LTD.) at 25 °C, a voltage range of 3.0 V to 4.3 V, and a discharge rate of 1.0 C/0.1 C to measure initial charge capacity, initial discharge capacity, initial efficiency, and 1.0 C/0.1 C rate performance.

For the same lithium secondary batteries (half-cell), after charging/discharging was performed 50 times using an electrochemical analysis device (Toscat-3100 from TOYO SYSTEM CO., LTD.) under conditions of 45 °C, a voltage range of 3.0 V to 4.3 V, and 1 C/1 C, the ratio of the discharge capacity at the 50th cycle to the initial capacity (cycle capacity retention) was measured.

The measurement results are shown in Table 3 below.

[Table 3]

| Classification | Charge capacity (mAh/g) | Discharge capacity (mAh/g) | Initial efficiency (%) | 5.0 C/0.1 Crate (%) | Retention@50cy (%) |
|---|---|---|---|---|---|
| Example 1 | 245.4 | 217.2 | 88.5 | 85.0 | 90.7 |
| Example 2 | 247.6 | 220.5 | 89.1 | 85.6 | 90.1 |
| Example 3 | 245.4 | 215.0 | 88.4 | 84.5 | 92.4 |
| Example 4 | 244.1 | 215.2 | 88.1 | 85.8 | 94.5 |
| Comparative Example 1 | 248.1 | 220.5 | 88.9 | 84.8 | 79.1 |

(continued)

| Classification | Charge capacity (mAh/g) | Discharge capacity (mAh/g) | Initial efficiency (%) | 5.0 C/0.1 Crate (%) | Retention@50cy (%) |
|---|---|---|---|---|---|
| Comparative Example 2 | 246.7 | 220.0 | 89.1 | 84.6 | 73.4 |
| Comparative Example 3 | 244.1 | 217.4 | 89.1 | 84.9 | 80.5 |
| Comparative Example 4 | 241.3 | 212.1 | 87.9 | 83.5 | 85.6 |

Referring to Table 3, it can be seen that the electrochemical properties of the lithium secondary batteries using positive electrode active materials according to Examples 1 to 4 which have a uniform particle size distribution and high sharpness of the particle size distribution were improved. In particular, it can be seen that the lifetime characteristics related to stability of the lithium secondary batteries using positive electrode active materials according to Examples 1 to 4 were improved.

According to the present invention, a positive electrode active material with reduced inter-particle agglomeration can be obtained by inducing uniform particle growth without harsh calcination conditions and a disintegration process through the use of a combination of a molten salt-based flux and a metal oxide-based dopant in the precursor calcination step.

The positive electrode active material obtained through the above process has a uniform particle size distribution and in particular, has high sharpness of the particle size distribution. When a positive electrode active material with high sharpness of the particle size distribution is used, the capacity and lifetime characteristics of a lithium secondary battery can be improved.

In addition to the above-described effects, specific effects of the present invention are described while explaining specific details for the present invention above.

Although embodiments of the present invention have been described above, those skilled in the art can make various modifications and changes to the present invention by adding, changing, or deleting components without departing from the spirit of the present invention as set forth in the claims, which will be included within the scope of rights of the present invention.

## Claims

1.  A positive electrode active material comprising a lithium composite oxide capable of intercalation/deintercalation of lithium,
    wherein the lithium composite oxide includes at least lithium and at least one metal, and satisfies Equations 1 to 3 below,

$$[\text{Equation 1}]$$
$$D_{90}/D_{10} \leq 3.62$$

$$[\text{Equation 2}]$$
$$D_{max} - D_{90} < 2.0\ \mu m$$

$$[\text{Equation 3}]$$
$$D_{max}/D_{min} < 5.19$$

in Equations 1 to 3, from the volume cumulative particle size distribution graph obtained by laser diffraction particle size distribution measurement, the particle size that corresponds to 10% of the volume cumulative amount is $D_{10}$, the particle size that corresponds to 50% of the volume cumulative amount is $D_{50}$, the particle size that corresponds to 90% of the volume cumulative amount is $D_{90}$, the minimum particle size in the volume cumulative particle size distribution graph is $D_{min}$, and the maximum particle size in the volume cumulative particle size distribution graph is $D_{max}$.

2. The positive electrode active material of claim 1, wherein the $D_{50}$ of the lithium composite oxide is an average particle diameter ranging from 2 μm to 8 μm.

3. The positive electrode active material of any one of claims 1 to 2, wherein the $D_{max}$ of the lithium composite oxide is 15 μm or less.

4. The positive electrode active material of any one of claims 1 to 3, wherein the lithium composite oxide satisfies Equation 4 below,

$$[\text{Equation 4}]$$
$$D_{50}/D_{10} < 1.19$$

5. The positive electrode active material of any one of claims 1 to 4, wherein the lithium composite oxide satisfies Equation 5 below,

$$[\text{Equation 5}]$$
$$D_{max} - D_{50} < 7.8 \ \mu m$$

6. The positive electrode active material of any one of claims 1 to 5, wherein the metal is at least one selected from nickel, cobalt, manganese, and aluminum.

7. The positive electrode active material of any one of claims 1 to 6, wherein the lithium composite oxide is represented by Chemical Formula 1 below,

[Chemical Formula 1]     $Li_aNi_{1-(b+c+d)}CO_bM1_cM2_dO_2$

Wherein,

M1 is at least one selected from Mn and Al,
M2 is at least one selected from Na, K, Mg, Ca, Ba, Mn, B, Ce, Hf, Ta, Cr, F, Al, V, Ti, Fe, Zr, Zn, Si, Y, Nb, Ga, Sn, Mo, W, P, Sr, Ge, Nd, Gd, and Cu,
M1 and M2 are different, and
$0.5 \leq a \leq 1.5$, $0 \leq b \leq 0.20$, $0 \leq c \leq 0.30$, $0 \leq d \leq 0.10$.

8. The positive electrode active material of claim 7, wherein in Chemical Formula 1, b+c+d is 0.30 or less.

9. The positive electrode active material of any one of claims 1 to 8, wherein the lithium composite oxide is present in at least one form selected from single particles and secondary particles in which a plurality of primary particles are aggregated.

10. The positive electrode active material of any one of claims 1 to 9, wherein the secondary particle is an aggregate of 2 to 10 primary particles.

11. A positive electrode comprising the positive electrode active material according to any one of claims 1 to 10.

12. A lithium secondary battery using the positive electrode according to claim 11.

EP 4 541 773 A1

FIG. 1

FIG. 2

FIG. 3

FIG. 4

FIG. 5

FIG. 6

Europäisches
Patentamt

European
Patent Office

Office européen
des brevets

# EUROPEAN SEARCH REPORT

**Application Number**

EP 24 20 5037

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/320506 A1 (MOON CHAE WON [KR] ET AL) 6 October 2022 (2022-10-06) \* examples \* | 1-12 | INV. C01G53/506 H01M4/525 |
| X | WO 2023/121147 A1 (POSCO HOLDINGS INC [KR]; RES INST IND SCIENCE & TECH [KR] ET AL.) 29 June 2023 (2023-06-29) \* examples \* | 1-12 | |
| E | & EP 4 456 188 A1 (POSCO HOLDINGS INC [KR]; RES INST IND SCIENCE & TECH [KR] ET AL.) 30 October 2024 (2024-10-30) \* examples \* | 1-12 | |
| A | CN 114 229 922 A (ZHEJIANG PAWATT NEW ENERGY CO LTD) 25 March 2022 (2022-03-25) \* examples \* \* figures \* | 1-12 | |

| | TECHNICAL FIELDS SEARCHED (IPC) |
|---|---|
| | C01G H01M |

The present search report has been drawn up for all claims

| Place of search | Date of completion of the search | Examiner |
|---|---|---|
| Munich | 17 March 2025 | Omegna, Anna |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**                  EP 24 20 5037

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2025

| Patent document cited in search report | Publication date | Patent family member(s) | | Publication date |
|---|---|---|---|---|
| US 2022320506 A1 | 06-10-2022 | CN | 115148985 A | 04-10-2022 |
| | | EP | 4183749 A1 | 24-05-2023 |
| | | EP | 4528835 A2 | 26-03-2025 |
| | | JP | 7356532 B2 | 04-10-2023 |
| | | JP | 2022159119 A | 17-10-2022 |
| | | JP | 2024001056 A | 09-01-2024 |
| | | KR | 20220135707 A | 07-10-2022 |
| | | KR | 20240017880 A | 08-02-2024 |
| | | KR | 20240018546 A | 13-02-2024 |
| | | KR | 20250004195 A | 07-01-2025 |
| | | KR | 20250004556 A | 08-01-2025 |
| | | US | 2022320506 A1 | 06-10-2022 |
| WO 2023121147 A1 | 29-06-2023 | CN | 118435379 A | 02-08-2024 |
| | | EP | 4456188 A1 | 30-10-2024 |
| | | KR | 20230095271 A | 29-06-2023 |
| | | WO | 2023121147 A1 | 29-06-2023 |
| CN 114229922 A | 25-03-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Journal of the Electrochemical Society*, 23 May 2017, vol. 164 (7), A1534-A1544